# EUROPÄISCHE PATENTANMELDUNG

(11) **EP 1 684 341 A2**
(43) Veröffentlichungstag der Anmeldung: **26.07.2006**
(21) Anmeldenummer: 06100171.5
(22) Anmeldetag: 09.01.2006
(51) Int. Cl.: H01L 21/68, H01L 23/538

(54) **Elektrische Schaltung und Verfahren zur Herstellung einer elektrischen Schaltung**

(30) Priorität: 21.01.2005 DE 102005200031
(71) Anmelder: ROBERT BOSCH GMBH, 70442 Stuttgart (DE)
(72) Erfinder: Rohde, Hartmut, 71397, Leutenbach (DE); Gaier, Stefan, 70599, Stuttgart (DE); Kugler, Andreas, 73553, Alfdorf (DE); Miessner, Ralf, 71634, Ludwigsburg (DE)

(57) **Zusammenfassung**

Elektrische Schaltung und Verfahren zur Herstellung einer elektrischen Schaltung, wobei die Schaltung elektrische Bauelemente aufweist, und wobei die Bauelemente mechanisch nur durch eine Vergussmasse miteinander verbunden sind und auf mindestens einer Seite der Vergussmasse mindestens eine Schicht Leiterbahnen aufweist, die die Bauelemente elektrisch miteinander verbinden. Das Herstellungsverfahren sieht vor, die Bauelemente auf eine Trägerfolie aufzubringen und die Bauelemente auf der Trägerfolie mit einer Vergussmasse zu umgiessen und anschließend die Trägerfolie zu entfernen und auf der Seite der mit der Vergussmasse umgossenen Bauelemente, die mit der Trägerfolie verbunden war, eine oder mehrere Schichten von Leiterbahnen aufzubringen, die die Bauelemente elektrisch miteinander verbinden.

## Beschreibung

### Stand der Technik

Die vorliegende Erfmdung betrifft eine elektrische Schaltung sowie ein Verfahren zur Herstellung einer elektrischen Schaltung, wobei die Schaltung elektrische Bauelemente aufweist und wobei die Bauelemente mechanisch nur durch eine Vergussmasse miteinander verbunden sind und auf mindestens einer Seite der Vergussmasse mindestens eine Schicht Leiterbahnen aufweist, die die Bauelemente elektrisch miteinander verbinden. Das Herstellungsverfahren sieht vor, die Bauelemente auf eine Trägerfolie aufzubringen und die Bauelemente auf der Trägerfolie mit einer Vergussmasse oder moulding compound zu umgießen und anschließend die Trägerfolie zu entfernen und auf der Seite der mit der Vergussmasse umgossenen Bauelemente, die mit der Trägerfolie verbunden war, eine oder mehrere Schichten von Leiterbahnen aufzubringen, die die Bauelemente elektrisch miteinander verbinden.

### Stand der Technik

Aus der DE 195 46 045 C1 ist ein Flip-Chip-Verfahren zur Herstellung eines Multichip-Moduls bekannt, wobei ein Substrat eine Mehrlagenschaltung, ein Bauelement und eine Wärmesenke erfindungsgemäß derart vereinigt werden, dass auf die Oberfläche der Mehrlagenschaltung zunächst z. B. im Siebdruck, Lot oder Leitkleber aufgebracht wird. Hierauf kann nun wahlweise zuerst ein Bauelement oder eine Wärmesenke aufgebracht werden, woran anschließend Bauelement und Wärmesenke mittels eines Wärmeleitklebers überzogen und thermisch kontaktiert werden. Diese Anordnung wird mit einer Kappe aus Kunststoff überdeckt, bevor sie auf ein mit Leiterbahnen versehenes Substrat aufgelötet oder aufgeklebt wird.

Die DE 103 24 615 A1 zeigt ein elektronisches Bauteil und ein Verfahren zur Herstellung, wobei das elektronische Bauteil Halbleiterchips aufweist, die in einer Kunststoffgehäusemasse mit ihren Rückseiten und ihren Seitenrändern angeordnet sind.

Dabei bilden die aktiven Oberseiten der Halbleiterchips und die Kunststoffgehäusemasse eine gemeinsame, eine Umverdrahtungslage tragende Oberseite aus. Auf der gegenüberliegenden Rückseite ist eine wärmeleitende Platte angeordnet, welche das Bauteil bedeckt.

Aus der DE 102 50 621 A1 ist ein Verfahren zum Erzeugen verkapselter Chips bekannt, bei dem ein Wafer mit Kontakten, die von der Oberfläche des Wafers vorstehen, vorbereitet wird. Der Wafer wird auf einem Zerteilungssubstrat angeordnet und in eine Mehrzahl von beabstandeten Chips auf dem Zerteilungssubstrat vereinzelt. Die Kontakte werden mit einer Schutzanordnung bedeckt, wobei daraufhin ein Spritzgießen durchgeführt wird, um ein Verkapselungsmaterial in die Kontakte um die Gräben einzubringen. Daraufhin wird die Schutzanordnung entfernt, so daß die Kontakte freiliegend sind.

Derartige Multi-Chip-Module, die aus dem Stand der Technik bekannt sind, werden derart aufgebaut, dass auf einer Leiterplatte bzw. einem Substrat, das als mechanischer Träger dient, Bauelemente aufgebracht und elektrisch miteinander verbunden werden. Zur Kontaktierung der Bauelemente wird häufig die Drahtbondtechnik eingesetzt, bei der mittels kurzer, elektrisch leitfähiger Bonddrähte Kontakte elektrisch miteinander verbunden werden. Hierbei werden die Bonddrähte zwischen den beiden Kontakten meist bogenförmig geformt, wodurch sogenannte Loops entstehen. Beim Einsatz in Hochfrequenzschaltungen weisen diese in Drahtbondtechnik hergestellten Loops parasitäre Induktivitäten und Kapazitäten auf, die kompensiert werden müssen. Da die Bonddrähte im Fertigungsprozess nicht alle exakt gleich lang sind und nicht alle Bonddrähte die gleiche, bogenförmige Form erhalten, sind die parasitären Induktivitäten und Kapazitäten, die durch Verbindung in Drahtbondtechnik entstehen, bei ansonsten gleichen Schaltungen unterschiedlich groß, so dass eine vollständige Kompensation dieser parasitären Effekte nicht möglich ist.

### Kern und Vorteile der Erfindung

Der Kern der vorliegenden Erfindung ist es dementsprechend, eine elektrische Schaltung sowie ein Verfahren zur Herstellung dieser elektrischen Schaltung anzugeben, bei dem elektrische Verbindungen zwischen Bauelementen reproduzierbare parasitäre Effekte aufweisen und bei dem empfmdliche Bauelemente eine hohe mechanische Beanspruchung aushalten können und dennoch kostengünstig hergestellt werden können.

Erfindungsgemäß wird dieses durch die Merkmale der unabhängigen Ansprüche gelöst. Vorteilhafte Weiterbildungen und Ausgestaltungen ergeben sich aus den Unteransprüchen.

Vorteilhafter Weise ist vorgesehen, dass die Bauelemente in der Vergussmasse derart versenkt sind, dass die elektrischen Anschlüsse der Bauelemente nicht mit Vergussmasse bedeckt sind. Durch die Versenkung der Bauelemente in der Vergussmasse erreicht man, dass diese mechanisch miteinander verbunden werden und auch empfindliche Bauelemente gegen mechanische Beanspruchung geschützt sind. Da die Bauelemente derart versenkt sind, dass die Seite der Bauelemente mit den elektrischen Anschlüssen möglichst plan aus der Vergussmasse herausragen, ist es möglich, mittels einer Schicht von elektrischen Leiterbahnen die elektrischen Anschlüsse der Bauelemente miteinander zu verbinden.

Weiterhin ist es vorteilhaft, dass mittels mechanischem Bohren und/oder mittels Laserbohren Sacklöcher und/oder durchgehende Löcher in die Vergussmasse gebohrt werden, die zur Herstellung elektrischer Kontakte metallisiert werden. Durch mechanisches Bohren oder durch Laserbohren ist es möglich, mittels Sacklöcher oder mittels durchgehender Löcher, die anschließend mit elektrisch leitendem Material, vorteilhafter Weise mittels eines flüssigen Metalls, metallisiert oder aufgefüllt werden, elektrische Verbindungen, oft auch als Vias bezeichnet, mit tiefer liegenden Schichten oder mit der Rückseite des Vergussmassestückes herzustellen.

Weiterhin ist es vorteilhaft, dass auf mindestens einer Schicht Leiterbahnen, die zur Verbindung der in der Vergussmasse versenkten Bauelemente aufgebracht wird, mindestens eine Schicht aus Dielektrikum aufzubringen. Durch die Schicht aus Dielektrikum, die in vorteilhafter Weise als Kunststoff mit angepasster Dielektrizitätszahl εᵣ ausgeführt sein kann, werden sowohl die elektrischen Leiterbahnen mechanisch geschützt, aber auch die Betriebsfrequenz der elektrischen Leiterbahnen für die Hochfrequenzsignale an die entsprechende Betriebsfrequenz angepasst, indem die Dicke der Dielektrikumsschicht auf die Betriebsfrequenz abgestimmt wird. Die angepasste Dielektrizitätszahl εᵣ liegt vorteilhafterweise zwischen 2 und 4.

Weiterhin ist es vorteilhaft, dass zur elektrischen Kontaktierung der Bauelemente mehrere Leiterbahnschichten übereinander vorgesehen sind, die durch Schichten aus Dielektrikum voneinander getrennt sind. Durch das Vorsehen mehrerer Leiterbahnschichten übereinander ist es möglich, beispielsweise eine Kontaktschicht zur Massekontaktierung vorzusehen und weitere Leiterbahnschichten zur Verbindung der elektrischen Anschlüsse der Bauelemente vorzusehen. Durch Schichten aus Dielektrikum, das vorteilhafter Weise als Kunststoff mit angepasster Dielektrizitätszahl εᵣ ausgeführt sein kann, werden die Metallisierungsebenen, die durch Strukturierung der Metallisierung zu Leiterbahnen strukturiert wurden, elektrisch gegeneinander isoliert sowie eine Ausbreitung hoher Betriebsfrequenzen auf den Leitungen ermöglicht. Da bei dieser Technik auf Drahtbondtechnik verzichtet werden kann, entstehen keinerlei Drahtloops, die individuell verschiedene parasitäre induktive oder kapazitive Effekte aufweisen, die in Folge unterschiedlicher Formen der Drahtloops auch unterschiedlich stark ausfallen können.

Weiterhin ist es vorteilhaft, dass auf der obersten Leiterbahnschicht zusätzliche elektrische Bauelemente vorsehbar sind. Auf der obersten Leiterbahnschicht können Kontaktflächen vorgesehen sein, auf denen zusätzliche Bauelemente, beispielsweise mittels Löten oder Kleben befestigt werden können, wodurch die Anzahl der Bauelemente nicht durch den räumlichen Platz der Vergussmasse begrenzt ist.

Weiterhin ist vorteilhaft, dass vor dem Aufbringen der Leiterbahnen Löcher oder Vertiefungen für Durchkontaktierungen in der Vergussmasse herstellbar sind.

Weiterhin ist es vorteilhaft, dass auf die Leiterbahnen und/oder zwischen den Leiterbahnschichten ein Dielektrikum aufgebracht wird. Dieses Dielektrikum ist beispielsweise ein Kunststoff mit angepasster Dielektrizitätszahl εᵣ, deren Dicke entsprechend der vorgesehenen Betriebsfrequenz der elektrischen Leitungen ausgelegt ist.

Vorteilhafter Weise sind auf der einen oder den mehreren Schichten von Leiterbahnen weitere Bauelemente aufbringbar.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in den Zeichnungen.

### Zeichnungen

Nachfolgend wird ein Ausführungsbeispiel der Erfindung anhand von Zeichnungen erläutert. Es zeigen

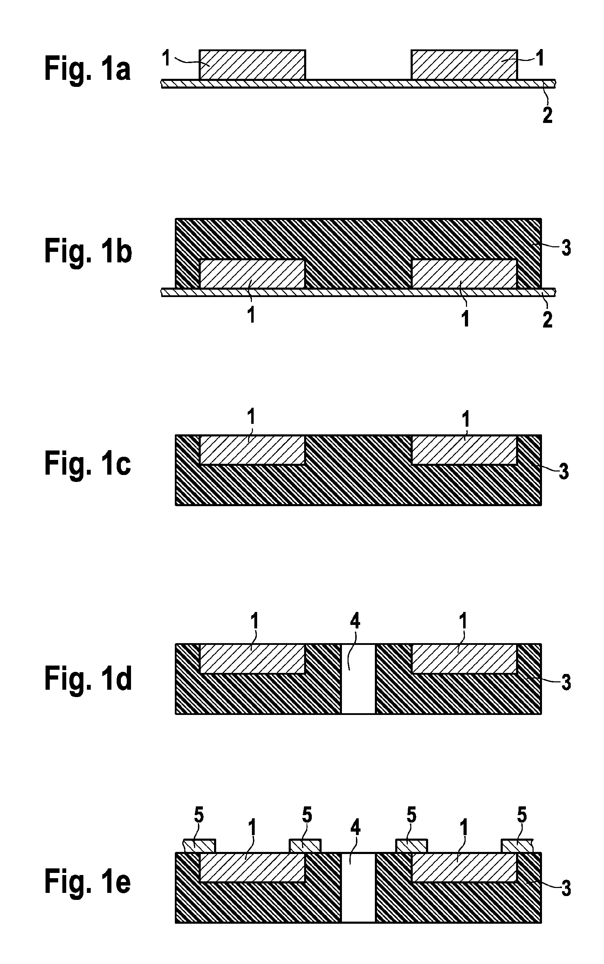

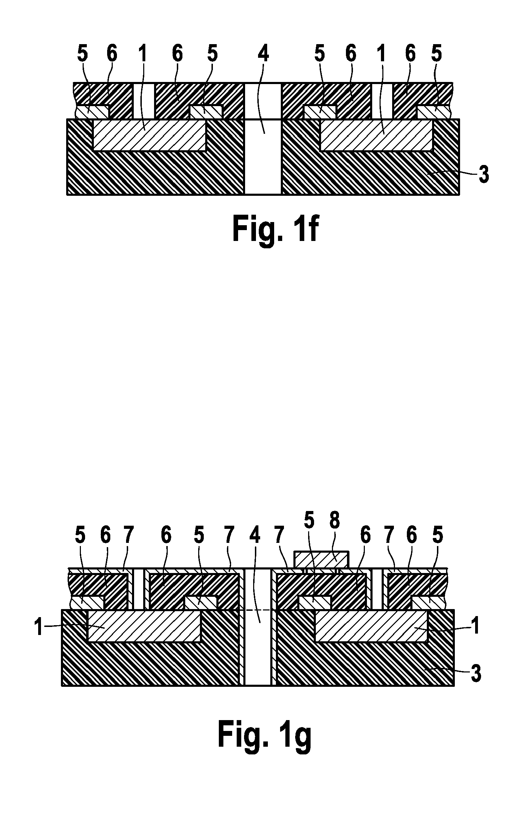

Figur 1a bis 1g mehrere Schritte der Herstellung einer erfindungsgemäßen Vorrichtung.

### Beschreibung von Ausführungsbeispielen

In Figur 1a ist der erste Schritt des erfindungsgemäßen Herstellungsverfahrens der erfindungsgemäßen elektrischen Schaltung dargestellt. Hierbei werden elektrische Hochfrequenzbauelemente auf eine Trägerfolie bestückt, wobei die Trägerfolie beispielsweise sogenanntes Bluetape sein kann, das auch zum Sägen von Wafern verwendet wird. Die elektrischen Hochfrequenzbauteile 1 werden auf die Trägerfolie 2 derart aufgeklebt, dass die Seite der Bauelemente, die die elektrischen Anschlüsse aufweist, auf die Bluetapefolie aufgeklebt werden. Hierbei werden die elektrischen Bauelemente 1 so auf der Trägerfolie 2 platziert, wie die Bauelemente 1 nachher in der elektrischen Schaltung angeordnet sein sollen. Gemäß einer weiteren Ausführungsform kann es weiterhin möglich sein, auf einzelne oder alle elektrischen Bauelemente 1 Kühlkörper aufzubringen, die für eine erhöhte Wärmeabfuhr während dem Betrieb der Bauelemente sorgen. Die optional vorsehbaren Kühlkörper werden hierbei auf die Seite der elektrischen Bauelemente 1 aufgesetzt, die der Trägerfolie 2 abgewandt ist.

Im darauffolgenden Schritt, wie er in Figur 1b dargestellt ist, werden die auf der Trägerfolie 2 aufgebrachten, elektrischen Bauelemente 1 mit einer Vergussmasse oder einem Moulding Compound umgossen, so dass alle elektrischen Bauelemente 1, die später in der elektrischen Schaltung vorgesehen sind, von der Vergussmasse 3 fixiert werden. Hierzu kann die Vergussmasse oder das Moulding Compound mittels eines Spritzgussverfahrens geformt werden. Gemäß einer vorteilhaften Ausgestaltung ist es weiterhin möglich, in das Stück Vergussmasse zusätzliche Vertiefungen oder Wannen zu formen, die als Platzhalter für später einzubringende Bauelemente oder Komponenten, wie beispielsweise Dielektrikumsschichten für Antennen, vorgesehen sein können.

Im darauffolgenden Schritt, wie er in Figur 1c dargestellt ist, wird die Trägerfolie 2 abgezogen, so dass die Seite der elektrischen Bauelemente 1, die die elektrischen Anschlüsse aufweist, wieder frei zugänglich ist. Die Flächen der elektrischen Bauelemente 1, die die Anschlusselemente aufweisen, bilden gemeinsam mit der Fläche der Vergussmasse, die mit der Trägerfolie 2 in Verbindung war, eine plane Fläche, auf der weitere Verbindungsstrukturen aufgebracht werden können. Durch das Aufkleben der elektrischen Bauelemente 1, deren Umspritzen mit Vergussmasse 3 und anschließendes Abziehen der Trägerfolie 2, werden die elektrischen Bauelemente 1 fest miteinander fixiert, wodurch eine mechanisch beanspruchbare, kompakte Einheit entsteht, die eventuell Kühlkörper, die mit den Bauelementen in Kontakt stehen, beinhaltet. Somit können auch empfindliche Bauelemente mechanisch stabil gekapselt werden.

Im nächsten Schritt, wie er in Figur 1d dargestellt ist, werden Löcher für Durchkontaktierungen 4 hergestellt. Hierzu werden in die Vergussmasse 3 mittels mechanischem Bohren oder mittels Laserbohren durchgehende Löcher 4 oder gegebenenfalls Sacklöcher 4 gebohrt, die später mit elektrisch leitendem Material beschichtet oder aufgefüllt werden können und somit Durchkontaktierungen (Vias) durch die Vergussmasse 3 darstellen. Gemäß einer weiteren Ausgestaltung der Erfindung kann es auch vorgesehen sein, die Durchkontaktierungen 4 bzw. die Sacklöcher 4 bereits beim Spritzgießen der Vergussmasse 3 zu formen, so dass eine Herstellung dieser Durchkontaktierungen, die auch als Vias bezeichnet werden, nicht mehr durch mechanisches Bohren oder Laserbohren hergestellt werden müssen, da diese bereits im Spritzgießverfahren ausgeformt wurden.

Im darauffolgenden Schritt, wie er in Figur 1e dargestellt ist, wird auf der Seite der Vergussmasse 3, auf der die elektrischen Bauelemente 1 eingelassen sind und die zuvor mit der Trägerfolie 2 in Kontakt waren, eine Leiterbahnschicht 5 hergestellt. Die Leiterbahnschicht 5 besteht hierbei aus elektrisch leitfähigem Material und verbindet Kontaktflächen der Bauelemente 1 untereinander bzw. stellt Anschlüsse der Bauelemente 1 nach außen her. Vorteilhafter Weise kann diese erste Leiterbahnschicht 5 auch als Masselage vorgesehen sein, die die elektrischen Bauelemente bzw. Flächen der hergestellten, elektrischen Schaltung mit einer anzuschließenden Masseverbindung kontaktiert. Diese erste Leiterbahnschicht 5 kann beispielsweise aufgedruckt werden, indem man ein Siebdruckverfahren mit Schablone anwendet oder ein Tampondruckverfahren verwendet. Hierbei kann beispielhafterweise eine Silberleitpaste verwendet werden, um eine gute elektrische Leitfähigkeit zu erhalten. Alternativ ist es auch möglich, diese erste Leiterbahnschicht 5 mittels einer Leitpaste herzustellen, die auf die Oberfläche der herzustellenden, elektrischen Schaltung aufgeschrieben wird. Gemäß einer weiteren Ausführung der Erfmdung ist es ebenfalls möglich, die Oberfläche der Vergussmasse 3, die die elektrischen Bauelemente 1 mit den elektrischen Anschlüssen aufweist, vollflächig zu metallisieren und mit bekannten Verfahren zu strukturieren. Hierzu kann beispielsweise ein Fotolack aufgetragen werden, der mittels Fotolithographieverfahren strukturiert wird und wodurch die vollflächig aufgebrachte Metallschicht teilweise entfernt wird, so dass sich eine strukturierte Leiterbahnschicht 5 ergibt. Anstatt der Strukturierung mit Fotolithographieverfahren ist es alternativ möglich, hierzu eine Laserablation zu verwenden, bei der nicht gewünschte Bereiche der vollflächigen Metallschicht mittels eines Laserstrahls entfernt werden und somit eine strukturierte Leiterbahnschicht 5 erzeugt wird.

Im nächsten Schritt, wie er in Figur 1f dargestellt ist, wird eine Schicht aus Dielektrikum 6 aufgetragen. Das Dielektrikum 6 ist vorteilhafter Weise ein Kunststoff mit angepasster Dielektrizitätszahl εᵣ, deren Dicke auf die vorgesehene Betriebsfrequenz der elektrischen Signale, die auf den Leitungen übertragen werden, angepasst ist. Diese Dielektrikumsschicht 6 kann beispielsweise aufgedruckt werden, indem ein Siebdruckverfahren verwendet wird, bei dem eine Schablone verwendet wird, die die Stellen der Schaltung bedruckt, an denen das Dielektrikum 6 erwünscht ist. Alternativ ist es auch möglich, hierfür ein Tampondruckverfahren zu verwenden oder die Dielektrikumslage 6 vollflächig auf der elektrischen Schaltung aufzutragen und mittels eines Fotolithographieverfahrens zu strukturieren. Als Dielektrikumsmaterial können beispielsweise die Materialien Polyimid (PI) oder Benzocyclobuten (BCB) verwendet werden, die bei der Passivierung von Wafern verwendet werden. In diesem Schritt werden auch Vertiefungen oder wannenförmige Aussparungen, die im vorherigen Spritzgießen ausgespart wurden, mit Dielektrikum 6 aufgefüllt, um dickere Dielektrikumsschichten zu erreichen.

Im darauffolgenden Schritt, wie er in Figur 1g dargestellt ist, wird auf das Dielektrikum 6 eine weitere Lage Leiterbahnen 7 aufgebracht. Diese weitere Leiterbahnebene 7 kann mit gleichen Verfahren, mit denen die Leiterbahnschicht 5 hergestellt wurde, erzeugt werden. Die Leiterbahnen 7 können hierbei elektrische Anschlüsse der Bauelemente 1 untereinander verbinden oder elektrische Verbindungen der elektrischen Bauelemente 1 nach außen herstellen. Hierzu ist es möglich, Leiterbahnen mittels eines Siebdruckverfahrens oder Tampondruckverfahrens aufzudrucken, indem beispielsweise ein Silberleitlack aufgedruckt wird. Alternativ ist es auch möglich, die Leiterbahnen mittels eines Schreibverfahrens mit Leitpaste direkt strukturiert aufzubringen. Alternativ ist es außerdem möglich, eine vollflächige Metallisierungsschicht 7 aufzubringen und diese mittels eines Fotolithographieverfahrens oder eines Laserabtragverfahrens so zu strukturieren, dass die gewünschten Leiterbahnen 7 übrig bleiben. Diese Leiterbahnschicht 7 wird weiterhin benutzt, die Durchkontaktierungen 4 mit einem leitfähigen Material zu versehen, indem die Durchkontaktierungen 4 mit einem elektrisch leitfähigen Material beschichtet werden oder komplett aufgefüllt werden. Hierdurch ist es möglich, elektrische Kontakte auf die Gegenseite der elektrischen Schaltung herzustellen, um beispielsweise externe Anschlussmöglichkeiten der elektrischen Schaltung zu erzeugen. Abschließend können zusätzlich weitere Bauelemente 8 auf die Leiterbahnen 7 gesetzt werden, die beispielsweise mittels Leitkleber oder mittels Lötverbindungen elektrisch mit den Leiterbahnen 7 verbunden werden. Hierdurch ist es möglich, zusätzliche Bauelemente 8 in die Schaltung einzubringen, die nicht, wie die elektrischen Bauelemente 1 mittels Vergussmasse 3 umspritzt werden. Hierdurch ist es möglich, mehr elektrische Bauelemente vorzusehen, als durch die verfügbare Fläche der Vergussmasse 3 mit den versenkten Bauelementen 1, möglich ist.

Die Leiterbahnschicht 7 kann alternativ auch wieder mit elektrisch isolierendem Material, beispielsweise eines Dielektrikums 6 bedeckt werden und zusätzliche Leiterbahnschichten aufgebracht werden, um auch komplexe Verbindungsstrukturen herzustellen. Erfindungsgemäß ist es weiterhin möglich, die elektrische Schaltung mittels Lotkugeln zu versehen, beispielsweise an den Stellen, an denen Durchkontaktierungen 4 auf die Unterseite der Vergussmasse vorhanden sind, so dass die erzeugte elektrische Schaltung wie ein SMD (Surface Mounted Device)-Bauelement weiterverarbeitet werden kann und in größere Schaltungen integriert werden kann. Hierbei dienen die Lotkugeln als Kontaktpunkte der erfindungsgemäß hergestellten Schaltung zu der größeren zu bestückenden Schaltung. Erfindungsgemäß ist es auch möglich, eine Vielzahl gleicher Schaltung mittels der beschriebenen Verfahrensschritte auf einmal herzustellen, die durch eine einstückig hergestellte Vergussmasse 3 gebildet wird und anschließend die Einzelschaltungen beispielsweise mittels Sägen auseinanderzutrennen, so dass die Herstellung in einem Vielfachnutzen erfolgt und nach Auseinandertrennung der Einzelnutzen die einzelnen Schaltungen weiter verwendet werden können. Hierdurch entsteht eine äußerst kostengünstige Herstellungsweise, bei der insbesondere für Hochfrequenzanwendungen keine unterschiedlichen parasitären kapazitiven oder induktiven Effekte entstehen, wie sie beispielsweise bei Verwendung von Drahtbondtechnik zwischen den elektrischen Bauelementen 1 bzw. 8 entstehen würden.

## Patentansprüche

1. Elektrische Schaltung, insbesondere Hochfrequenzschaltung, die elektrische Bauelemente (1) aufweist, wobei die Bauelemente (1) mechanisch nur durch eine Vergussmasse (3) miteinander verbunden sind und auf mindestens einer Seite der Vergussmasse (3) mindestens eine Schicht Leiterbahnen (5,7) vorgesehen sind, die die Bauelemente (1) elektrisch miteinander verbinden.

2. Elektrische Schaltung nach Anspruch 1, **dadurch gekennzeichnet, dass** die Bauelemente (1) in der Vergussmasse (3) derart versenkt sind, dass die elektrischen Anschlüsse der Bauelemente (1) nicht mit Vergussmasse (3) bedeckt sind.

3. Elektrische Schaltung nach Anspruch 1 oder 2, **dadurch gekennzeichnet, dass** mittels mechanischem Bohren und/oder mittels Laserbohren Sacklöcher (4) und/oder durchgehende Löcher (4) in die Vergussmasse (3) gebohrt werden, die zur Herstellung elektrischer Kontakte metallisiert (7) werden.

4. Elektrische Schaltung nach einem der vorhergehenden Ansprüche, **dadurch gekennzeichnet, dass** auf der mindestens einen Schicht Leiterbahnen (5,7) mindestens eine Schicht aus Dielektrikum (6) aufgebracht ist.

5. Elektrische Schaltung nach Anspruch 4, **dadurch gekennzeichnet, dass** die Dicke und/oder die Dielektrizitätskonstante (εᵣ) der Dielektrikumsschicht (6) an die Betriebsfrequenz der zu verarbeitenden, elektrischen Signale angepasst ist.

6. Elektrische Schaltung nach einem der vorhergehenden Ansprüche, **dadurch gekennzeichnet, dass** zur elektrischen Kontaktierung der Baulemente (1) mehrere Leiterbahnschichten (5,7) übereinadner vorgesehen sind, die durch Schichten aus Dielektrikum (6) voneinander getrennt sind.

7. Elektrische Schaltung nach einem der vorhergehenden Ansprüche, **dadurch gekennzeichnet, dass** auf der obersten Leiterbahnschicht (7) zusätzliche elektrische Bauelemente (8) vorsehbar sind.

8. Verfahren zur Herstellung einer elektrischen Schaltung, insbesondere für Hochfrequenzanwendungen, wobei Bauelemente (1) auf eine Trägerfolie (2) aufgebracht werden, die Bauelemente (1) auf der Trägerfolie (2) mit einer Vergussmasse (3) umgossen werden, anschließend die Trägerfolie (2) entfernt wird und auf der Seite der mit der Vergussmasse (3) umgossenen Bauelemente (1), die mit der Trägerfolie (2) verbunden war, eine oder mehrere Schichten von Leiterbahnen (5,7) aufgebracht werden, die die Bauelemente (1) elektrisch miteinander verbinden.

9. Verfahren nach Anspruch 8, **dadurch gekennzeichnet, dass** vor dem Aufbringen der Leiterbahnen (5,7) Löcher oder Vertiefungen für Durchkontaktierungen (4) in der Vergussmasse (3) herstellbar sind.

10. Verfahren nach Anspruch 8 oder 9, **dadurch gekennzeichnet, dass** auf die Leiterbahnen (5,7) und/oder zwischen den Leiterbahnschichten (5,7) ein Dielektrikum (6) aufgebracht wird.

11. Verfahren nach einem der Ansprüche 8 bis 10, **dadurch gekennzeichnet, dass** auf der einen oder den mehreren Schichten von Leiterbahnen (5,7) weitere Bauelemente (8) aufbringbar sind.
